# EUROPÄISCHE PATENTSCHRIFT

(11) **EP 0 772 805 B1**
(45) Veröffentlichungstag und Bekanntmachung des Hinweises auf die Patenterteilung: **22.09.1999**
(21) Anmeldenummer: 95928475.3
(22) Anmeldetag: 27.07.1995
(51) Int. Cl.: G05B 19/10

(54) **VERFAHREN UND SCHALTUNGSANORDNUNG ZUR NICHTLINEAREN REGELUNG VON BETRIEBSPARAMETERN**
OPERATIONAL PARAMETER NON-LINEAR REGULATION PROCESS AND CIRCUITRY
PROCEDE ET CIRCUITERIE DE REGULATION NON LINEAIRE DE PARAMETRES DE FONCTIONNEMENT

(30) Priorität: 29.07.1994 DE 4426885
(43) Veröffentlichungstag der Anmeldung: 14.05.1997
(73) Patentinhaber: GRUNDIG Aktiengesellschaft, 90762 Fürth (DE)
(72) Erfinder: KAGERBAUER, Gottfried, D-90425 Nürnberg (DE)
(86) Internationale Anmeldenummer: EP9502968
(87) Internationale Veröffentlichungsnummer: WO9604595

(56) Entgegenhaltungen:
- EP-A- 0 335 161
- DE-A- 3 048 991
- US-A- 4 203 063
- PATENT ABSTRACTS OF JAPAN vol. 11 no. 195 (E-518) ,23.Juni 1987 & JP,A,62 021315 (ALPINE ELECTRON INC.) 29.Januar 1987,

## Beschreibung

Die Erfindung betrifft ein Verfahren zur nichtlinearen Regelung von Betriebsparametern eines elektrischen Geräts gemäß dem Oberbegriff des Patentanspruchs 1 und eine Schaltungsanordnung zur Durchführung dieses Verfahrens gemäß dem Oberbegriff des Patentanspruchs 5.

Aus der DE 36 05 088 A1 ist eine Bedieneinrichtung bekannt, welche einen Drehknopf zur Auswahl verschiedener Betriebszustände aufweist. Bei einem Aufzeichnungsgerät mit einer derartigen Bedieneinrichtung wird die Geschwindigkeit des Aufzeichnungsmediums in Abhängigkeit von der Umdrehungsgeschwindigkeit des Drehknopfes geregelt. Hierbei besteht eine proportionale Kopplung zwischen der Umdrehungsgeschwindigkeit des Drehknopfes und der Geschwindigkeit des Aufzeichnungsmediums.

Ein Nachteil dieser Realisierung besteht darin, daß die Geschwindigkeit des Aufzeichnungsmediums nicht schnell verändert werden kann, da bei einer sehr genauen Regelung mehrere Umdrehungen des Drehknopfes erforderlich sind, oder daß sie nicht genau genug eingestellt werden kann, wenn der gesamte Regelbereich mit nur einer Umdrehung eingestellt werden kann.

Aus der EP 290 803 B1 ist eine Einknopfbedienung für den Rangierbetrieb bei Videomagnetbandrecordern bekannt. Die Transportgeschwindigkeit wird in Abhängigkeit der Stellung eines Drehknopfes festgelegt. Die Geschwindigkeit, mit der der Drehknopf betätigt wird, wird jedoch nicht ausgewertet.

Von Nachteil dabei ist auch hier, daß sich die Bandgeschwindigkeit entweder nicht schnell genug verstellen läßt oder daß die Einstellung zu ungenau ist.

Der vorliegenden Erfindung liegt daher die Aufgabe zugrunde, sowohl eine genaue Einstellung von Betriebsparametern zu ermöglichen als auch eine Möglichkeit vorzusehen die Einstellungen schnell zu ändern.

Erfindungsgemäß wird diese Aufgabe durch die Merkmale der Patentansprüche 1 und 5 gelöst.

Das erfindungsgemäße Verfahren weist den Vorteil auf, daß mit einem Impulsgeber, der nur langsam bzw. mit normaler Geschwindigkeit gedreht wird, eine dem Drehwinkel proportionale Änderung des einzustellenden Parameters erfolgt, die für eine sehr genaue Einstellung genügend klein gewählt werden kann. Wird der Impulsgeber schnell gedreht, so werden abgespeicherte Werte eingestellt, die unabhängig vom Drehwinkel sind. Dadurch ist sowohl eine sehr schnelle als auch eine sehr genaue Parameteränderung möglich.

Aus US 42 03 063 ist ein Verfahren und eine entsprechende Anordnung zur Frequenzeinstellung bekannt. Die Frequenzeinstellung kann automatisch odr manuell erfoglen. Bei der automatischen Frequenzeinstellung wird ein Frequenzeinsteller beim Abruf gespeicherter Frequenzen automatisch eingestellt. Dabei wird aus einem Speicher ein Wert für eine gewünschte Frequenz einem Komparator zugeleitet, der einen Vergleich mit dem derzeit eingestellten Wert vornimmt. Ist die Differenz zwischen eingestelltem und einzustellendem Wert groß, erzeugt der Komparator ein Signal zur schnellen Verstellung, ist die Differenz mittel, erzeugt der Komparator ein Signal zur normalen Verstellung und ist die Differenz klein, erzeugt der Komparator ein Signal zur langsamen Verstellung. Das jeweilige Signal wird dann über einen D/A-Wandler einem Motor zugeleitet, der den Frequenzeinsteller mit der entsprechenden Geschwindigkeit verstellt. Somit ist ein Verfahren und eine Schaltungsanordnung zur unterschiedlich schnellen Einstellung einer gespeicherten Frequenz mittels eines Frequenzeinstellers bekannt.

Dabei ist von Nachteil, daß die Frequenzänderung während eines Einstellvorgangs immer von der Motorgeschwindigkeit abhängig ist, mit der der Frequenzeinsteller gedreht wird. Somit existiert immer ein linearer Zusammenhang zwischen Frequenz und Drehwinkel. Soll die Frequenz wesentlich verändert werden, muß so lange gedreht werden, bis der gesamte dazwischenliegende Bereich überwunden ist.

Bei der manuellen Frequenzeinstellung wird die überstrichene Frequenz in Abhängigkeit der Drehgeschwindigkeit der manuellen Einstelleinheit ermittelt.

Hierbei ist von Nachteil, daß die Frequenzänderung während eines Einstellvorgangs immer von der Drehgeschwindigkeit der manuellen Einstelleinheit abhängig ist, mit welcher der Frequenzeinsteller gedreht wird. Somit existiert immer ein Zusammenhang zwischen Frequenz und Drehwinkel. Soll die Frequenz wesentlich verändert werden, muß so lange gedreht werden, bis der gesamte dazwischenliegende Bereich überwunden ist.

Der vorliegenden Aufgabe liegt daher die Aufgabe zugrunde, sowohl eine genaue Einstellung von Betriebsparametern zu ermöglichen, als auch eine Möglichkeit vorzusehen über Extremalwerte oder abgespeicherte Werte die Einstellung schnell zu ändern.

Vorteilhafte Ausgestaltungen sind den Unteransprüchen zu entnehmen.

Die Schaltungsanordnung nach Anspruch 5 weist den Vorteil auf, daß sie eine Einstellung der Parameter sowohl in Abhängigkeit des Drehwinkels des Impulsgebers als auch in Abhängigkeit der Drehgeschwindigkeit des Impulsgebers realisiert.

Dabei kann der ohnehin meist vorhandene Mikroprozessor mitbenutzt werden.

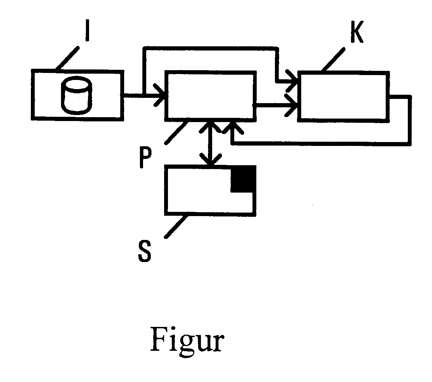

Die Erfindung wird im folgenden anhand der in der Zeichnung dargestellten Ausführungsform näher erläutert und beschrieben. Die Figur zeigt ein Blockschaltbild der erfindungsgemäßen Schaltungsanordnung, das eine Möglichkeit zur schaltungstechnischen Realisierung darstellt.

Als Ausführungsbeispiel wird die Lautstärkeregelung bei einem Empfänger betrachtet. Es besteht insbesondere bei Autoradios die Notwendigkeit Bedienelemente möglichst klein zu realisieren, da der Platz auf der Frontblende sehr begrenzt ist. Daher ist auch nur ein kleiner Regler für die Lautstärke vorgesehen. Um mit einem derartigen Regler eine ausreichend genaue Einstellung der Lautstärke zu erreichen, ist es erforderlich den Regelbereich in mehreren Umdrehungen des Drehknopfs des Reglers zu überstreichen. Dies behindert jedoch eine schnelle Einstellung der Lautstärke, die beispielsweise beim Herannahen eines Rettungsfahrzeuges oder bei einem ankommenden Telefonanruf erforderlich sein kann.

Daher wird bei einer langsamen bzw. normalen Betätigungsgeschwindigkeit des Drehknopfes für die Lautstärkeeinstellung die Änderung der Lautstärke in bekannter Art und Weise in Abhängigkeit von dem Drehwinkel festgelegt. Die Proportionalität zwischen Drehwinkel und dadurch bedingtem Lautstärkeunterschied wird so festgelegt, daß auch geringe Lautstärkeunterschiede noch eingestellt werden können. Dadurch erhält man meist Drehwinkel größer 360 Grad, die durch Verwendung eines Impulsgebers realisiert werden können.

Zusätzlich zur bekannten linearen Regelung wird bei einer schnellen Drehung des Drehknopfes die Lautstärke nicht mehr proportional dem Drehwinkel eingestellt. Es wird vielmehr in Abhängigkeit von der Drehrichtung eine abgespeicherte Lautstärke eingestellt. Wird der Drehknopf schnell in Richtung geringerer Lautstärke gedreht, so wird die Lautstärke auf Null gesetzt, das Autoradio also stumm geschaltet. Wird anschließend der Drehknopf schnell in Richtung größerer Lautstärke gedreht, so wird eine mittlere Lautstärke (Zimmerlautstärke) oder die vorherige Lautstärke eingestellt. Zur Einstellung einer mittleren Lautstärke ist es erforderlich, daß z.B. bei der Fertigung entsprechende Parameterwerte für Lautstärke und sonstige einstellbare Parameter in einem Speicher S abgespeichert werden. Zur Einstellung der vorher gewählten Lautstärke wird diese automatisch bei einer esten derartigen schnellen Änderung in einen Speicher S eingeschrieben und bei einer anschließenden zweiten schnellen Drehung des Drehknopfes in die andere Richtung wieder ausgelesen und eingestellt.

Dadurch kann auch verhindert werden, daß (z.B. aufgrund einer Fehlbedienung) plötzlich oder ungewollt eine zu große Lautstärke vorliegt, da diese nur langsam in Abhängigkeit vom Drehwinkel und nicht durch Auslesen eines großen Lautstärkewerts aus dem Speicher S eingestellt werden kann.

Beim Einsatz in einem Regler zur Gewichtung hoher oder tiefer Frequenzen im Ausgabesignal wird durch eine besonders schnelle Drehbewegung des Reglers ein Mittelwert oder ein oberer bzw. unterer Extremalwert eingestellt.

Die Schaltungsanordnung zur Realisierung dieses Verfahrens besteht aus einem Impulsgeber I, der vom Benutzer betätigt wird. Das Ausgangssignal des Impulsgebers I wird einem Mikroprozessor zugeleitet, der als Steuereinheit P des Geräts dient. Nach Auswertung der Impulsanzahl pro Zeiteinheit, die ein Maß für die Drehgeschwindigkeit ist, wird diese Zahl durch einen Komparator K mit einem abgespeicherten Schwellwert verglichen. Weiterhin wird durch einen Vergleich aufeinander folgender Ausgangssignale des Impulsgebers I in der Steuereinheit P dessen Drehrichtung festgestellt. Falls der Schwellwert überschritten wird, liest die Steuereinheit P in Abhängigkeit der von ihr festgestellten Drehrichtung des Impulsgebers I und dem davor eingestellten Wert einen Extremalwert aus dem Speicher S aus, auf den der zu verändernde Parameter eingestellt wird. Der Speicher S wird durch die Steuereinheit P daher in Abhängigkeit von dem zu verändernden Parameter, der Drehrichtung und dem vorher eingestellten Wert adressiert.

## Patentansprüche

1. Verfahren zur nichtlinearen Regelung von Betriebsparametern, bei dem die Änderung des Betriebsparameters proportional zum Drehwinkel eines Drehknopfes erfolgt, die Drehgeschwindigkeit des Drehknopfes ermittelt wird und der Betriebsparameter bei Betätigung des Drehknopfes in Abhängigkeit von der Drehrichtung verändert wird,
**dadurch gekennzeichnet,**
daß der Betriebsparameter bei Betätigung des Drehknopfes und Überschreiten eines Schwellwertes für die Drehgeschwindigkeit in Abhängigkeit von der Drehrichtung und/oder dem gerade eingestellten Parameter unverzüglich auf einen Extremalwert oder einen dafür abgespeicherten Parameterwert eingestellt wird.

2. Verfahren nach Anspruch 1,
**dadurch gekennzeichnet,**
daß zur Ermittlung der Drehgeschwindigkeit die lmpulszahl pro Zeiteinheit des vom Benutzer über den Drehknopf betätigten Impulsgebers (I) ermittelt wird.

3. Verfahren nach Anspruch 2,
**dadurch gekennzeichnet,**
daß es zur Regelung der Lautstärke, der Höhen, der Tiefen und der Balance bei Mehrkanalwiedergabe eingesetzt wird.

4. Verfahren nach Anspruch 3,
**dadurch gekennzeichnet,**
daß zwischen Minimalwert für den jeweiligen Betriebsparameter und einem häufig benutzten Wert weitere Zwischenwerte für eine schnelle Einstellung vorgesehen sind, die in Abhängigkeit von der Betätigungsdauer des Drehknopfes eingestellt werden.

5. Schaltungsanordnung zur nichtlinearen Regelung von Betriebsparametern, welche einen vom Benutzer betätigten Impulsgeber (I) und eine Schaltung zur Feststellung der Drehrichtung des lmpulsgebers aufweist, deren Ausgangssignale einer Steuereinheit (P) zugeleitet werden und die Steuereinheit (P) einen Zähler aufweist, welcher die Impulse pro Zeiteinheit im Ausgangssignal des lmpulsgebers (I) zählt,
**dadurch gekennzeichnet,**
daß die Steuereinheit (P) einen Komparator (K) aufweist, welcher das Ausgangssignal des Zählers mit einem aus einem Speicher (S) ausgelesenen Schwellwert vergleicht,
daß ein Speicher (S) vorgesehen ist, um Schwellwerte, Extremalwerte und häufg benutzte Werte für verschiedene Betriebsparameter zu speichern,
und daß die Steuereinheit (P) Mittel aufweist, die, wenn der Quotient aus Impulsen pro Zeiteinheit den abgespeicherten Schwellwert überschreitet, einen der abgespeicherten Werte für den ausgewählten Betriebsparameter in Abhängigkeit von der Drehrichtung aus dem Speicher (S) ausliest und diesen Betriebsparameter für den weiteren Betrieb benutzt.

6. Schaltungsanordnung nach Anspruch 5,
**dadurch gekennzeichnet,**
daß die Steuereinheit (P) ein Mikroprozessor ist.

## Claims

1. Method for the nonlinear loop control of operating parameters, in which the operating parameter is changed in proportion to the angle of rotation of a rotary knob, the speed of rotation of the rotary knob is determined and the operating parameter is altered as a function of the direction of rotation when the rotary knob is actuated, characterized in that, if the rotary knob is actuated and a threshold value is exceeded for the speed of rotation, the operating parameter is set immediately to an extreme value or a parameter value stored therefor as a function of the direction of rotation and/or the parameter which has just been set.

2. Method according to Claim 1, characterized in that the number of pulses per unit time of the pulse generator (I) actuated by the user via the rotary knob is determined in order to determine the speed of rotation.

3. Method according to Claim 2, characterized in that it is used to control the volume, the treble notes, the bass notes and the balance in the case of multi-channel reproduction.

4. Method according to Claim 3, characterized in that, between the minimum value for the respective operating parameter and a frequently used value, further intermediate values which are set as a function of the actuating time of the rotary knob are provided for rapid setting.

5. Circuit arrangement for the nonlinear loop control of operating parameters, which has a pulse generator (I) actuated by the user and a circuit for determining the direction of rotation of the pulse generator, whose output signals are fed to a control unit (P), and the control unit (P) has a counter which counts the pulses per unit time in the output signal of the pulse generator (I), characterized
in that the control unit (P) has a comparator (K) which compares the output signal of the counter with a threshold value read out of a memory (S),
in that a memory (S) is provided in order to store threshold values, extreme values and frequently used values for various operating parameters,
and in that the control unit (P) has means which, if the quotient of pulses per unit time exceeds the stored threshold value, reads out of the memory (S) one of the stored values for the selected operating parameter as a function of the direction of rotation and uses said operating parameter for the subsequent operation.

6. Circuit arrangement according to Claim 5,
characterized in that the control unit (P) is a microprocessor.

## Revendications

1. Procédé de régulation non linéaire de paramètres de fonctionnement, selon lequel la variation du paramètre de fonctionnement s'effectue proportionnellement à l'angle de rotation d'un bouton rotatif, la vitesse de rotation du bouton rotatif est déterminée et le paramètre de fonctionnement est modifié lors de l'actionnement du bouton rotatif en fonction du sens de rotation, caractérisé en ce
que lors de l'actionnement du bouton rotatif et du dépassement d'une valeur de seuil pour la vitesse de rotation, le paramètre de fonctionnement est réglé immédiatement en fonction du sens de rotation et/ou du paramètre précisément réglé, sur une valeur extrême ou sur une valeur de paramètre mémorisée à cet effet.

2. Procédé selon la revendication 1, caractérisé en ce
que pour la détermination de la vitesse de rotation le nombre d'impulsions par unité de temps du générateur d'impulsions (I) actionné par l'utilisateur au moyen du bouton rotatif, est déterminé.

3. Procédé selon la revendication 2, caractérisé en ce
qu'on l'utilise pour la régulation de l'intensité acoustique, des aiguës, des basses, et l'équilibre lors de la reproduction à canaux multiples.

4. Procédé selon la revendication 3, caractérisé en ce
qu'entre la valeur minimale pour le paramètre considéré de fonctionnement et une valeur utilisée fréquemment sont prévues d'autres valeurs intermédiaires pour un réglage rapide, qui sont réglées en fonction de la durée d'actionnement du bouton rotatif.

5. Montage pour la régulation non linéaire de paramètres de fonctionnement, qui comporte un générateur d'impulsions (I) actionné par l'utilisateur et un circuit pour déterminer le sens de rotation du générateur d'impulsions, dont les signaux de sortie sont envoyés à une unité de commande (P), et dans lequel l'unité de commande (P) comporte un compteur, qui compte les impulsions par unité de temps dans le signal de sortie du générateur d'impulsions (I), caractérisé en ce
que l'unité de commande (P) comporte un comparateur (K) qui compare le signal de sortie du compteur à une valeur de seuil lue dans une mémoire (S),
qu'il est prévu une mémoire (S) servant à mémoriser des valeurs de seuil, des valeurs extrêmes et des valeurs fréquemment utilisées pour différents paramètres de fonctionnement, et
que l'unité de commande (P) comprend des moyens qui, lorsque le quotient d'impulsions par unité de temps dépasse la valeur de seuil mémorisée, lisent l'une des valeurs mémorisées pour le paramètre de fonctionnement sélectionné, en fonction du sens de rotation, à partir de la mémoire (S) et utilisent ces paramètres de fonctionnement pour la poursuite du fonctionnement.

6. Montage selon la revendication 5, caractérisé en ce
que l'unité de commande (P) est un microprocesseur.
